# EUROPEAN PATENT APPLICATION

(11) **EP 4 841 990 A2**
(43) Date of publication of application: **18.11.2026**
(21) Application number: 26189183.2
(22) Date of filing: 16.02.2024
(51) Int. Cl.: H04N 19/91

(54) **APPARATUS AND METHOD FOR DETERMINING A NEURAL NETWORK REPRESENTATION**

(30) Priority: 22.02.2023 EP 23158084
(62) Document number(s) of the earlier application(s) in accordance with Art. 76 EPC: 24704840.8 / 4 670 089
(71) Applicant: Fraunhofer-Gesellschaft zur Förderung der angewandten Forschung e.V., 80686 München (DE)
(72) Inventor: HAASE, Paul, 10587 Berlin (DE); PFAFF, Jonathan, 10587 Berlin (DE); SCHWARZ, Heiko, 10587 Berlin (DE); MARPE, Detlev, 10587 Berlin (DE); WIEGAND, Thomas, 10587 Berlin (DE)
(74) Representative: Schenk, Markus

(57) **Abstract**

An apparatus for determining, by training, a neural network representation suitable for being encoded using quantization and binary context-adaptive entropy coding is presented. The apparatus is configured to, cyclically, perform forward-passes using a quantized versionof weights of a neural network or using the weights of a neural network, determine a weights-to-bitrate or weights-to-bitlength function by determining, for each of a plurality of entropy coding contexts, a probability estimate depending on statistics of binary strings obtained from quantization indices of quantization levels of the weights by binarization using a predetermined binarization scheme, or the quantization indices, and determining a discrete function mapping the quantization levels or the quantization indices onto bitrates by determining bit lengths for binary strings which comprise one or more context-adaptive entropy coded bins using a summation over, for each of the one or more context-adaptive entropy coded bins, a logarithmized version of the probability estimate of the entropy coding context for the respective context-adaptive entropy coded bin, forming the weights-to-bitrate or weights-to-bitlength function by a summation of, for each of the weights, an approximation function approximating the discrete function at an abscissa position corresponding to the respective weight; form a combined loss function based on a performance loss function of the forward-passes and the weights-to-bitrate or weights-to-bitlength function, determine, for each weight, a gradient of the combined loss function and using the gradient to update the respective weight for a next cycle.

## Description

Embodiments described herein relate to apparatuses and methods for determining a neural network representation, in particular to a bitrate-performance optimized model training for the neural network coding (NNC) standard.

In August 2022, ISO/IEC MPEG published the first international standard on compression of neural networks, namely Neural Network Coding (NNC, MPEG-7 part 17). It compresses neural networks to about 5% to 15% in size at virtually no performance loss. In NNC, the model weights are usually quantized and then encoded into the bitstream using DeepCABAC entropy coding. In order to improve the coding efficiency, this disclosure presents new training strategies for optimized model weights considering the quantization and entropy coding process of NNC, by making the training process bitrate- and quantization-aware. With this bitrate-performance optimized training the bitrate can be further reduced by more than 25% in average for state-of-the-art image classification models.

NNC, DeepCABAC, MPEG, neural network compression, rate-performance optimization

### 1 Introduction

The recent success in many machine learning (ML) tasks, e.g. in image classification, natural language processing, object detection or video coding, is driven by deep neural networks (NNs) [1] and the availability of large amounts of data. The highly active research conducted over the past years yielded new methods and model architectures which demonstrated remarkable advances in all of the aforementioned fields. These advances came along with an increased complexity and, especially, with a massive growth in the number of neuron interconnections [1]. State-of-of-the-art neural networks employ millions or even billions of parameters or weights representing the neuron interconnections. At the same time, many ML tasks require distribution of NNs across several devices (e.g mobile devices) or frequent communication of NN parameters between devices as, for example, in federated learning [3][4]. Consequently, storage and transmission of NNs becomes a challenging task, in particular, if resources (e.g. bandwidth or memory) are limited. This shows that there is a demand for efficient compression of NNs. In order to address this demand, in August 2022, the ISO/IEC Moving Picture Experts Group (MPEG) released the first international standard on compression of neural networks, namely Neural Network Coding (NNC) [5]. NNC achieves high compression virtually without performance loss by applying selected methods for parameter reduction, preprocessing, quantization as well as DeepCABAC [6] entropy coding. Recent work focuses on parameter reduction [7] or optimizing encoder parameters and settings [8] in order to reduce the model size or improve the coding efficiency. However, the rate-performance trade-off is largely determined by the quantization and DeepCABAC entropy coding stage and thus depends on the distribution of the quantization indices of the NN weights and their sensitivity to quantization. This disclosure presents new training methods to obtain optimized model weights which consider NNCs quantization and entropy coding. By making the training process bitrate- or bitrate- and quantization-aware, the compression efficiency can be improved significantly.

This is achieved by the subject matter of the independent claims of the present application.

### 1.1 Summary of the invention

According to an embodiment, an apparatus for determining, by training, a neural network representation suitable for being encoded using quantization and binary context-adaptive entropy coding, is configured to, cyclically, perform forward-passes using a quantized version of weights of a neural network or using the weights of a neural network, and to determine a weights-to-bitrate or weights-to-bitlength function by determining, for each of a plurality of entropy coding contexts, a probability estimate depending on statistics of a binary strings obtained from quantization indices of quantization levels of the weights by binarization using a predetermined binarization scheme, or the quantization indices, determining a discrete function mapping the quantization levels or the quantization indices onto bitrates by determining bit lengths for binary strings which comprise one or more context-adaptive entropy coded bins using a summation over, for each of the one or more context-adaptive entropy coded bins, a logarithmized version of the probability estimate of the entropy coding context for the respective context-adaptive entropy coded bin, forming the weights-to-bitrate or weights-to-bitlength function by a summation of, for each of the weights, an approximation function approximating the discrete function at an abscissa position corresponding to the respective weight. The apparatus is further configured to form a combined loss function based on a performance loss function of the forward-passes and the weights-to-bitrate or weights-to-bitlength function, determine, for each weight, a gradient of the combined loss function and using the gradient to update the respective weight for a next cycle.

It has been recognized that performing a statistics of such binary strings (or the quantization indices) can yield information about the distribution of the weights and subsequently allows determining or approximating a bitlength of bitrate that could be expected if the weights were binary context-adaptive entropy coded. However, since the bitlength or bitrate is determined from the weights (which can be quantized and represented by quantization levels or the quantization indices) such bitrates or bitlengths are primarily assigned to quantization levels or the quantization indices, forming a discrete function. By approximating the discrete function at an abscissa position corresponding to the respective weight, a plurality of approximation functions can be obtained that can form a differentiable function while also being linked to the respective weight (due to the abscissa position). As a result, weights-to-bitrate or weights-to-bitlength function is based on a sum of functions that are parameterizable in a vicinity of the weight (due to the abscissa position). The a combined loss function has the performance loss function (which can be indicative of the performance of the neural network for different weight values) and the weights-to-bitrate or weights-to-bitlength function (which can be indicative of a bitrate for different weight values). Therefore, the combined loss function is accessible to gradient analysis for updating (or adjusting) the weights. The combined loss function is a valuable tool for training and encoding of the neural network. For example, after a forward-pass the combined loss function can be used to optimize (e.g., using stochastic gradient decent) the weights not only in regards to the network performance, but also in regards to an efficiency of codeability of the weights. For example, the network weights may be primarily adjusted in order to improve the performance, but also simultaneously adjusted (e.g., to a much smaller degree, e.g., less than 5% or less than 1%) to also adjust the weights for more efficient codability. The method may, for example, be employed at multiple training iterations (or cycles), e.g., for the purpose of coding (e.g., for transmitting) the weights in between training cycles, or at an end of a training.

Further embodiments according to the invention are defined by the subject matter of the dependent claims of the present application.

This disclosure is organized as follows. First, a short overview of NNC is given with an emphasis on quantization and entropy coding. Then, the bitrate-performance optimized training strategies are described in detail and, finally, the performance is evaluated by applying the training methods to selected state-of-the-art NN models.

### 1.2 Brief Description of the Drawings

The drawings are not necessarily to scale, emphasis instead generally being placed upon illustrating the principles of the invention. In the following description, various embodiments of the invention are described with reference to the following drawings, in which:
- Fig. 1: shows a schematic example of Quantization-aware training (QAT) with simulated quantization in the forward-pass and straight-through estimator (STE) in the backward pass;
- Fig. 2: shows a schematic example of a bitrate- and quantization-aware training with bitrate estimation and interpolation;
- Fig. 3: shows an example of results for QAT and Bitrate-performance optimized training for ResNet50;
- Fig. 4: shows an example of results for QAT and Bitrate-Performance optimized training for MobileNetV2;
- Fig. 5: shows a table of an example of compression gains for bitrate-performance optimized training and selected working points;
- Fig. 6: shows a flow diagram for an example of method according to the first approach;
- Fig. 7: shows a flow diagram for an example of method according to the second approach;
- Fig. 8: shows a schematic view of a neural network;
- Fig. 9: shows an example of a probability estimation of an entropy coding context for context adaptive entropy coded bins;
- Fig. 10: shows a schematic view of an example of a bitstream, having, by binary context-adaptive entropy coding, a neural network representation encoded there-into; and
- Fig. 11: shows a schematic view of examples of coding contexts for encoding and for training.

### 2 Overview of the Neural Network Coding (NNC) standard

Typically, neural network (NN) encoding with NNC involves three stages starting with an optional parameter reduction or preprocessing step followed by parameter quantization and, finally, DeepCABAC entropy coding of the quantization indices. The first stage provides optional tools, which aim at a more compact model representation, removing redundancy in the tensors or partly compensating the quantization error of the quantization stage, see [5] and [8] for more details.

In the second stage, the model parameters are quantized such that the resulting quantization indices can be transmitted losslessly. This step typically further compresses the model. NNC specifies a set of quantization methods, which comprise scalar quantization with a uniform reconstruction quantizer (URQ), a vector quantization scheme, referred to as dependent quantization or trellis-coded quantization (TCQ) [9], and encoding of integer codebooks as, for example, output by k-means clustering algorithms. For all quantization methods, a quantization step size is derived from an integer quantization parameter (QP), which provides the main mechanism for controlling the rate-performance trade-off. Generally, the bitrate and the model performance decrease for coarser quantization and increase for finer quantization.

In a final step, the integer indices output by the quantization process are arithmetically coded using DeepCABAC [6], which represents an adaptation of context-based adaptive binary arithmetic coding (CABAC) [10] for compression of neural networks. For each quantization index, a series of binary decisions, so-called bins, may be encoded. A first bin *SigFlag* (significance flag) may specify whether an index is non-zero or not. It may be followed by a bin *SignFlag* which may indicate the value of the sign, and by a series of bins *AbsGr*(*nᵢ*)*Flag*s (*nᵢ* = 1,2, ... ,10) that may determine if the absolute value of the current quantization index is greater than *nᵢ*. The encoding may be terminated whenever the *SigFlag* or a *AbsGr*(*nᵢ*)*Flag* equals zero. Otherwise, i.e. if there is a remainder, it may be encoded using an Exponential Golomb code [11]. The bins of *SigFlag*, *SignFlag* and *AbsGr*(*nᵢ*)*Flag* may be associated with so-called context models, each representing a probability estimator which adapts to the source statistics. In order to exploit local dependencies, a context model may be selected out of a set of candidates based on a context (e.g. previously coded bins in a local neighborhood). For example, if scalar quantization (URQ) is applied, the selection process may be as follows. For each of the flags *SigFlag* and *SignFlag,* three context models are provided. The selection of the corresponding model may be determined by the value (negative, zero or positive) of the quantization index directly preceding the current quantization index. For each *AbsGr*(*nᵢ*)*Flag* a model may be selected out of a set of two candidates, based on the value of the preceding *SignFlag*. The arithmetic coding engine then may encode the bins into the bitstream according to the estimated statistics.

An NNC compliant decoder may process all steps in reverse order, i.e. entropy decoding with DeepCABAC, followed by reconstruction of the quantized model parameters and, if necessary, inverting preprocessing methods.

### 3 Rate-performance optimized training

In this section it will be shown that the compression efficiency can be improved significantly by optimizing the weights with respect to the entropy coding process of the quantization indices employed by NNC. More precisely, we present a new bitrate-performance optimized model training by making the training process bitrate- and quantization-aware. Currently, our design only considers scalar quantization with URQ for the sake of simplicity. For a better understanding, first the new strategy for bitrate-aware training is described in section 3.1 and then quantization-aware training is reviewed in section 3.2, separately. Finally, the new rate-performance optimized training which combines both approaches is derived in section 3.3.

### 3.1 Bitrate-aware training

Bitrate-aware training (BAT) is a new method, which considers the bits required for representing the compressed weights during the model training process. The idea is to train the weights with respect to a loss measure *L*_{*R*,*P*} which integrates both, the bitrate *R* and the performance loss *L_{P}*. This may be achieved by applying a Lagrangian cost function according to: ${L}_{P , R} = {L}_{P} + λR ,$ (1) where *λ* is a Lagrange multiplier and a bitrate *R* is the number of bits normalized by an overall number of weights.

Here, the central problem is to appropriately model the bitrate using a differentiable function. As mentioned before, computing the bitrate required for encoding a weight *ωᵢ* may involve quantization and determining the number of bits output by the arithmetic coding stage for the quantization index. Thus, due to the quantization step, gradients of the bitrate with respect to the weights are then either zero or undefined and hence, the approach of gradient-based learning would have no effect. This issue can be solved by first estimating the bitrate required for each possible quantization index and then, for example, linearly interpolating the bitrate between the discrete bitrate points, which may provide piecewise constant gradients. In order to determine a point on the bitrate curve for a weight, the quantization may be simulated by dividing the weight by the quantization step size but skipping a rounding operation. This can be interpreted as shifting the weights into a quantized domain, while the weights always remain in full precision. The procedure described above may then be repeated for each training step (training data batch).

Now, the remaining problem may be to accurately model the bitrate for the quantization indices. For this purpose, each quantization index ${q}_{i} ∈ ℤ$ is may be decomposed into a series of bins *s_{k,i}* (binarization), for example, as specified by NNC (see section 2). Here, *k* = 0 may correspond to the *SigFlag, k =* 1 may correspond to the *SignFlag, k =* 2 to the *AbsGr*1*Flag* and so on. Thus, for example, *s*_{0,*i*} may denote the *SigFlag* of the quantization index *qᵢ.* Then, the bitrate *R*(*qᵢ*) for each quantization index *qᵢ* may be given by a sum of bits Σ*ₖ b*(*s_{k,i}*) required for encoding the associated bins *s*_{*k*,*i*}, divided by the overall number of weights. Usually, the bits *b*(*s_{k,i}*) may be obtained by encoding the bins with DeepCABAC according to the NNC specification. However, due to DeepCABACs complexity and local dependencies introduced by the context modeling stage, this may not be feasible for each training step. Accordingly, a simplified bitrate model may be employed as described in the following.

Since, arithmetic coding is nearly optimal, if the source statistics are known, the number *b*(*s_{k,i}*) of bits required to transmit a bin *s_{k,i}* may be modeled by: $b \left({s}_{k , i}\right) = \left(\begin{matrix}- {log}_{2} \left({p}_{{s}_{k , i}}\right) & , if {s}_{k , i} = 1 \\ - {log}_{2} \left(1-{p}_{{s}_{k , i}}\right) & , if {s}_{k , i} = 0\end{matrix}\right. ,$ (2) where *p_{sₖ,i}* is the probability of bin *s_{k,i}* being equal to one. In fact, practical implementations like DeepCABAC may come with a small overhead caused by limited precision, and initialization and termination of the bitstream. However, if the number of symbols to be encoded is large, this overhead can be considered negligible. Accordingly, the bitrate for each bin that uses a context model (e.g. *SigFlag*, *SignFlag*, *AbsGr*(*nᵢ*)*Flags*) can be approximated as follows. First, the empirical probability *p_{sₖ,i}* that the bin is equal to one may be determined, e.g., based on the distribution of the weights in the tensor. Then, the number of bits may be estimated using equation (2). Bins that are associated with a remainder and, thus, usually coded using an Exponential Golomb code, may be modeled using one bit per bin.

In order to avoid local dependencies, a simplified context modelling scheme for *SigFlag* and *SignFlag* may be employed. For example, each of the flags may select one out of a set of three context models (probability estimators), based on the value of a directly preceding quantization index (e.g., qᵢ₋₁). Since, the impact on the bitrate may be rather small, for simplicity, only a single probability estimate may be used for each of the flags. For example, the bitrate for a whole tensor may then be the sum of the bitrates for each quantization index (e.g., of the respective tensor). The whole estimation process may then be repeated at the beginning of each training step.

### 3.2 Quantization-aware training

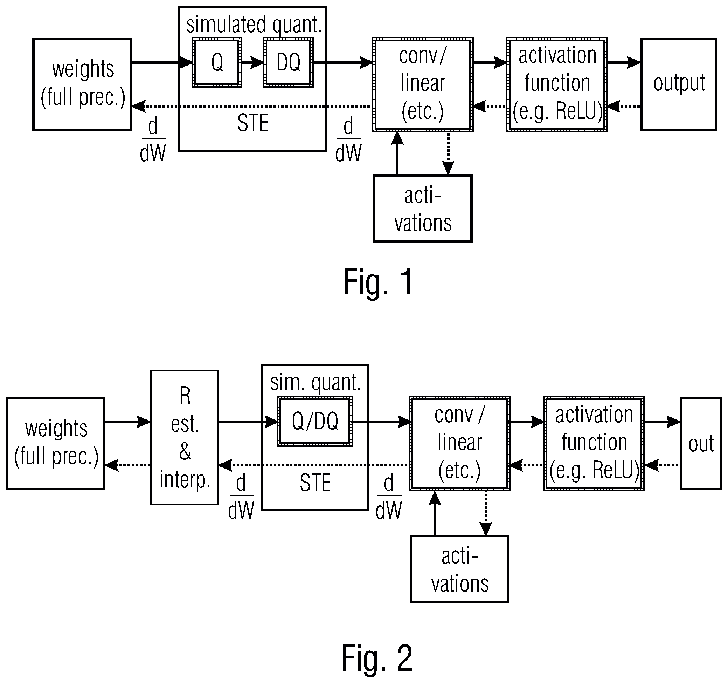

Figure 1 shows a schematic example of Quantization-aware training (QAT) with simulated quantization in the forward-pass (black arrows, e.g., arrows pointing towards the right and pointing away from "Activations") and straight-through estimator (STE) in the backward pass (red arrows, e.g., arrows pointing towards the left and pointing towards "Activations").

Post-quantization (PQ) of the weights, as used in NNC, usually degrades the model accuracy. With the well-known quantization-aware training (QAT) [12, 13, 14] the model performance can be improved, e.g., by including the quantization in the training graph and then retraining the weights with respect to the quantization error. Analogously to bitrate-aware training (BAT), the main challenge in QAT is that the gradients of the quantization operation are either zero or undefined. However, this problem may be solved using the approach in [12], which introduces a simulated quantization in the forward-pass and a so-called straight-through estimator [13, 14] in the backward pass, as illustrated in Fig. 1. Here, simulated quantization means quantization and subsequent de-quantization according to: ${{ω}^{˜}}_{i} = \left⌊\frac{{ω}_{i}}{Δ}+\frac{1}{2}\right⌋ ⋅ Δ ,$ (3) where *ω̃ᵢ* is the de-quantized version of the i-th weight *ωᵢ* of a tensor to be processed and Δ is the quantization step size.

One advantage of simulated quantization is that it adds a quantization error and the weights can remain in a floating point representation at the same time. This ensures that no changes to the neural network training framework or the loss function are required and all model operations in the forward-pass can be performed directly with the weights output by the simulated quantization stage.

In the backward pass, the gradients of the loss function are computed with respect to the weights (e.g., d/dW). The straight-through estimator (STE) bypasses the gradient computation of quantization-dequantization operation such that the gradients are passed through the simulated quantization operation. These gradients are then used to update the full precision weights. Here, in contrast to [12], the activations remain in full precision, since quantization in NNC only applies to the weights.

### 3.3 Bitrate- and quantization-aware training

Figure 2 shows a schematic example of a bitrate- and quantization-aware training with bitrate estimation (R rest.) and interpolation (interp.), and simulated quantization (simulated quant.) in the forward-pass (black arrows, e.g., arrows pointing towards the right and pointing away from "Activations") and straight-through estimator (STE) in the backward pass (red arrows, e.g., arrows pointing towards the left and pointing towards "Activations").

Making the training process bitrate- and quantization-aware can be achieved by combining aspects of the methods described in sections 3.1 and 3.2 as exemplarily illustrated in Fig. 2. For example, for each training step, first the bitrate *R* may be determined, e.g., according to the bitrate-aware training (BAT) approach in section 3.1, which requires the weights to be represented non-quantized. Following the method in section 3.2, simulated quantization may be applied in a second step and may yield the performance loss *Lₚ*. The overall loss *L_{P,R}* may then, for example, be computed as given by equation (1).

For the backward pass, the gradients of the combined loss function may be determined with respect to the weights, e.g., now considering both the bitrate and the quantization error. As described in section 3.2 the straight-through estimation approach may, for example, be used to propagate the gradients through the simulated quantization (see Fig. 1) in order to update the full precision weights.

### Detailed Description of the Embodiments

Equal or equivalent elements or elements with equal or equivalent functionality are denoted in the following description by equal or equivalent reference numerals even if occurring in different figures.

In the following description, a plurality of details is set forth to provide a more throughout explanation of embodiments of the present invention. However, it will be apparent to those skilled in the art that embodiments of the present invention may be practiced without these specific details. In other instances, well-known structures and devices are shown in block diagram form rather than in detail in order to avoid obscuring embodiments of the present invention. In addition, features of the different embodiments described herein after may be combined with each other, unless specifically noted otherwise.

The invention will be described primarily in form of a method. However, an apparatus (e.g., a computer) may be provided that is configured to perform the method (and any variation disclosed herein). The method and apparatus are for determining, by training, a neural network representation suitable for being en-coded using quantization and binary context-adaptive entropy coding.

The method comprises performing forward-passes 12 using a quantized version ŵᵢ of weights wᵢ of a neural network 10 or using the weights of a neural network 10. The quantized version ŵᵢ of the weights wᵢ may be indicative of quantization levels (e.g., which indicate what values a parameter can assume in the respective quantization, e.g., a step size Δ or scaling according to a step size Δ) and a quantization index (e.g., a parameter that identifies or indexes a quantization level and/or a scale for the quantization step size Δ).

According to one approach (e.g., "bitrate and quantization aware training"), the method may be carried out using a quantized version of weights of a neural network. According to a second approach (e.g., "bitrate aware training"), the method may be carried out using weights of a neural network.

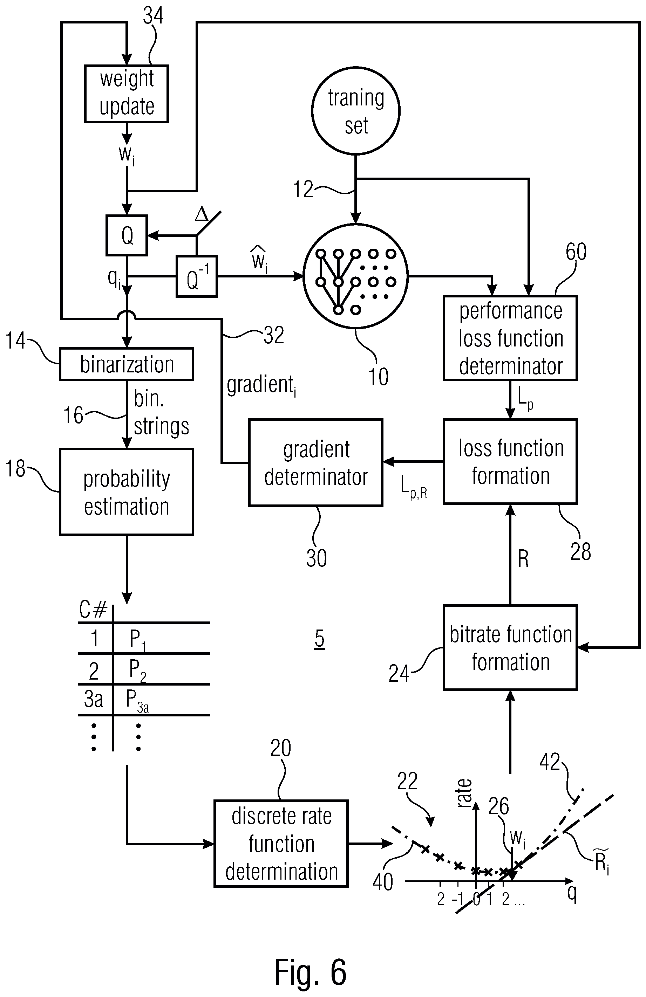

Figure 6 shows a flow diagram 5 for an example of method according to the first approach.

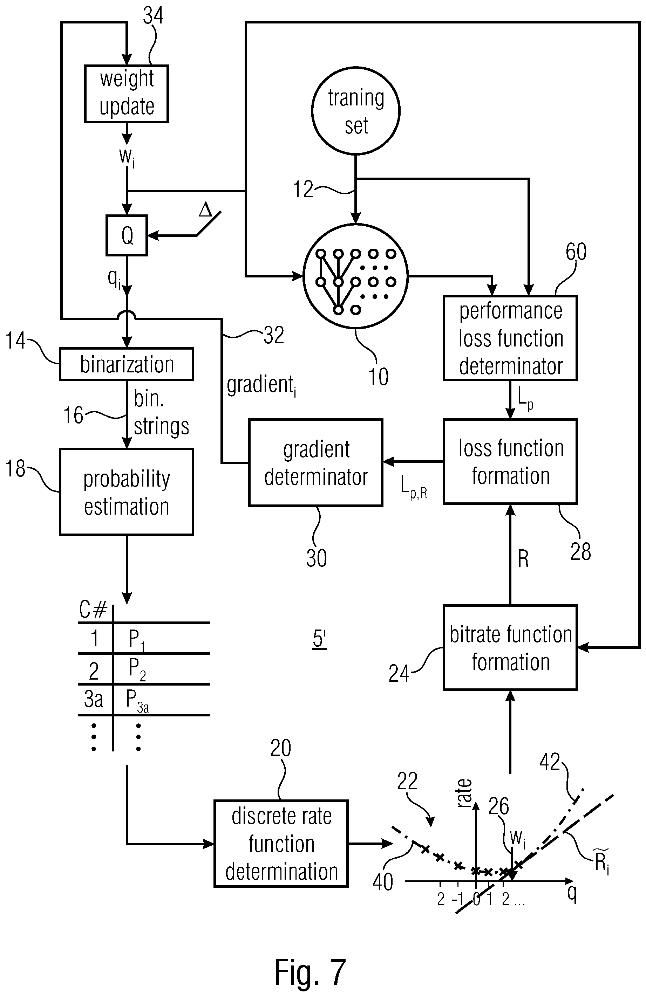

Figure 7 shows a flow diagram 5' for an example of method according to the second approach.

The method according to flow diagram 5 and 5' may essentially differ in whether the forward-pass is performed using the weights in form of a quantized version or unquantized version.

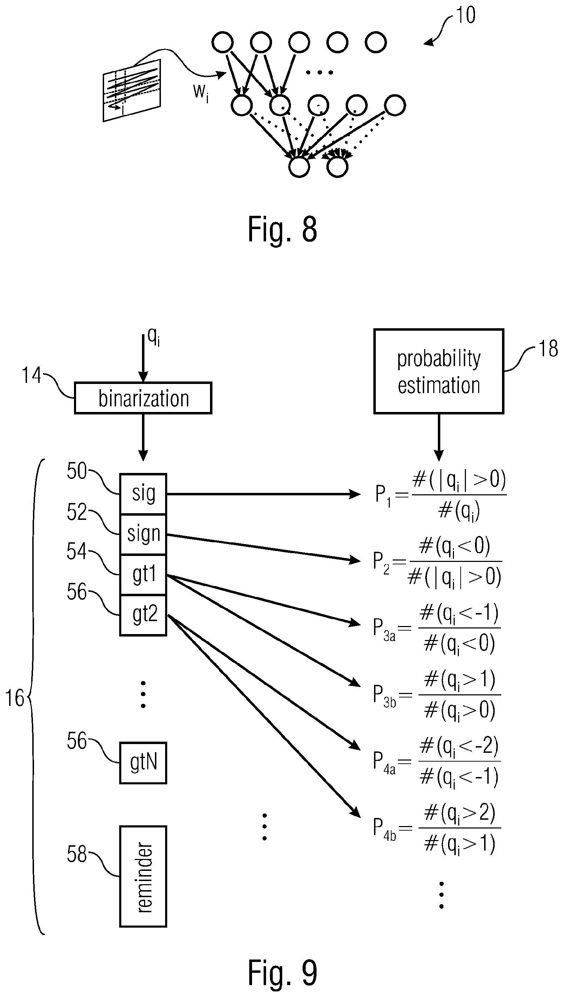

Figure 8 shows a schematic view of a (at least a portion of a) neural network 10. In the example shown in figure 8, the neural network has three layers, but any other number of layers may be used. Each layer comprises a plurality of nodes or artificial neurons (indicates as circles). Nodes of a layer are connected to other layers (or itself, e.g., in case of a recursive network). Such connections include the transmission of an input wherein each connection between two nodes may be weighted by a weight wᵢ. The weights of a network (or a layer or a part thereof) may be arranged in a matrix (see left side of figure 8), which may be accessible to mathematical operations that can be used for realizing at least parts of the method disclosed herein. The neural network 10 may be a complete or closed network or the network 10 may be a part (e.g., a sub network, a layer of a network, a tensor of a network, or a part of a tensor of a network) of a larger neural network.

The method may comprise using a quantization (e.g. linear quantization which may be scalar quantization or dependent or trellis-based quantization) using a predetermined quantization step size (Δ) so as to determine the quantized version of the weights and determine the quantization indices of quantization levels of the weights, respectively. For example, the forward-pass may be performed using the (unquantized) weights of the neural network. In such a case, the method may include using quantization (e.g., using a predetermined quantization step size Δ or using a step size determined based on the weights or using a varying step size). A quantization may, for example, not be necessary, if a quantized version ŵᵢ of weights wᵢ is already available (e.g., performed by a different entity or as a result of a previous quantization).

Quantization (e.g. linear quantization which may be scalar quantization or dependent or trellis-based quantization) may use a predetermined quantization step size (Δ) so as to determine the quantized version of the weights and determine the quantization indices of quantization levels of the weights, respectively. For example, the quantized version (ŵᵢ) of weights (wᵢ) may be determined as or based on the following equation: $\hat{{w}_{ι}} = \left⌊\frac{{w}_{i}}{Δ}+\frac{1}{2}\right⌋ ⋅ Δ$

Such a quantization has low processing complexity and may include a quantization level at zero (which can occur often in neural networks). However, any other form of quantization may be used instead (e.g., using a ceiling function and/or using quantization levels that does not include a zero).

The quantized version (ŵᵢ) of weight may be indexed in the quantization levels using a quantization index qᵢ (e.g., the quantization index qᵢ may index the quantization level of the quantized version ŵᵢ of the weight). A linear or a non-linear quantization may be used.

The method comprises determining a weights-to-bitrate or weights-to-bitlength function R. A bitlength is commonly defined as the number of binary digits, called bits, necessary to represent a number (such as a weight). However, it should be noted that the bitlength determined (or approximated) in this method does not necessarily have to be an integer (e.g., a length of one, two, or three bits), but can be a non-integer number. Such a representation can be used here, as a statistic determination is performed and can be understood easier further below in the context of logarithmized versions of probability estimates.

The bitrate may be indicative of or define a number of bits (e.g., a bitlength) normalized by a reference value. The reference value may be independent of the value of the weights. For example, the reference value may be (or be indicative of) an overall number of weights (e.g., of the network 10; e.g., over a number of weights of a tensor, over a subset of weights in a tensor, of one or more matrices and/or layers). For example, the bit rate may be a bitlength divided by an overall number of weights (e.g., a bit rate of 3 bits for 1000 weights).

The reference value may be (or be indicative of) a target amount of bits (e.g., to be used to code the weights of the network or a subset thereof, over a subset of weights of a tensor and/or layers). The reference value may be dependent on a subset (e.g., a layer of the neural network). For example, the different layers of the neural network may have a different target amount of bits.

Determining the weights-to-bitrate or weights-to-bitlength function R comprises determining 18, for each of a plurality of entropy coding contexts, a probability estimate P_{C#} depending on statistics of binary strings 16 obtained from quantization indices qᵢ of quantization levels ŵᵢ of the weights wᵢ by binarization 14 using a predetermined binarization scheme.

Alternatively, determining the weights-to-bitrate or weights-to-bitlength function R comprises determining 18, for each of a plurality of entropy coding contexts, a probability estimate P_{C#} depending on statistics the quantization indices. The quantization indices themselves may comprise or be indicative flags (e.g., significance or sign), which allows determining statistics that are indicative of a bitlength.

The binarization may map the quantization indices (e.g., qᵢ) onto the binary strings so that the binary strings 16 comprise a significance flag 50 indicative of whether a quantization index to be quantized is zero or not. Any flag disclosed herein may be a binary flag (e.g., either one or zero) with two states (e.g., one state for true, positive, or non-zero and one for false, negative or zero).

If the quantization index to be quantized is not zero, the binary strings 16 may comprise a sign flag 52 indicative of whether the quantization index to be quantized is negative or positive. Furthermore, if the quantization index to be quantized is not zero, the binary strings 16 may comprise a greater-than-one flag 54 indicative of whether a magnitude of the quantization index to be quantized is greater than one or not.

If the magnitude of the quantization index to be quantized is greater than one, the binary strings 16 may comprise up to N-1 greater-than-X flags 56 indicative of whether a magnitude of the quantization index to be quantized is greater than X or not, with X assuming values from 2 to N, and if the to be quantized is greater than N, a remainder binarization 58. The binary strings 16 may only comprise greater-than-X flags 56 until one greater-than-X flags 56 indicates that the magnitude of the quantization index is not greater than X (e.g., in which case the bit string 16 may not comprise a further greater-than-X' flag 56 with X'>X of a previous greater-than-X flag 56 already indicates that the magnitude is not greater than X).

The significance flag 50, the sign flag 52, the greater-than-one flag 54 and the N-1 greater-than-X flags 56 may be (or form a basis for) the context-adaptive entropy coded bins. Bins of the remainder binarization may be coded (at least partially coded; e.g., an Exp-Golomb code might be used for the remainder; e.g., a prefix might be coded using context while suffix might be coded using bypass coding) using bypass coding (e.g. a code rate of 1, or a fixed equi-probability estimate).

The binarization may map the quantization indices qᵢ onto the binary strings so that the binary strings 16 comprise a significance flag 50 (e.g., a one bit flag) indicative of whether a quantization index to be quantized is zero or not. If the quantization index to be quantized is not zero, a sign flag 52 (of the binary strings 16) may be indicative of whether the quantization index to be quantized is negative or positive. The binary strings 16 may comprise a greater-than-one flag 54 indicative of whether a magnitude of the quantization index to be quantized is greater than one or not. The binary strings may only comprise subsequently flags (e.g., sign flag 52, greater-than-one flag 54) dependent on previous flags. For example, the binary strings 16 may not comprise subsequent flags for a quantization index qᵢ, if the significance flag 50 already indicates that the quantization index qᵢ is to be quantized is zero.

If the magnitude of the quantization index to be quantized is greater than one, the binary strings 16 may comprise up to N-1 greater-than-X flags 56 indicative of whether a magnitude of the quantization index to be quantized is greater than X or not, with X assuming values from 2 to N, and if the to be quantized is greater than N, a remainder binarization 58. The binary strings 16 may not comprise any subsequent greater-than-X flags 56 for a the quantization index qᵢ once a (current) greater-than-X flags 56 indicates that a magnitude of the quantization index us not greater than X.

Fig. 6 and 7 show, at their left side, a table wherein a first column of the table contains coding contexts C#. The table serves to illustrate examples of coding contexts and how they may be mapped or assigned to corresponding estimates probability estimates (e.g., P₁, P₂, and P₃ₐ). However, the coding contexts C# do not have to be stored or processed in a table.

The method may comprise using one first entropy coding context C1 for the significance flag 50, one second entropy coding context C2 for the sign flag 52. For example, fig. 6 and 7 show that coding context C1 is mapped or assigned to a probability estimate P₁. As will be discussed further below with reference to fig. 9, the probability estimate P₁ may be mapped or assigned to the significance flag 50 and the probability estimate P₂ may be mapped or assigned to the sign flag 52.

The method may comprise using for each of the greater-than-one flag and N-2 greater-than-X flag, a respective third entropy coding context C#b (e.g., C3b) if the sign flag of the binary string to which the respective of the greater-than-one flag and N-2 greater-than-X flag belongs, indicates positiveness (e.g., qᵢ>0), and a respective fourth entropy coding context C#a (e.g., C3a) if the sign flag of the binary string to which the respective of the greater-than-one flag and N-2 greater-than-X flag belongs, indicates negativeness (e.g., qᵢ<0). Similarly, the method may comprise using a fifth and sixth entropy coding context C4b, C4a in combination with a greater-than-2 flag 56 if the sign flag of the respective binary string 16 indicates positiveness or negativeness.

Generally, the method may comprise using at least one (e.g., one or two) entropy coding contexts per flag 50, 52, 54, 54, and 56 that is comprised in the binary string 16. The method may comprise using one entropy coding contexts each for the significance flag 50 and the sign flag 52 (as far as available in the bit string 16). The method may comprise using two entropy coding contexts each for the greater-than-one flag 54 and the greater-than-X flag 56 (as far as available in the bit string 16).

Determining the weights-to-bitrate or weights-to-bitlength function R comprises determining 20 a discrete function 22 mapping the quantization levels or the quantization indices onto bitrates by determining bit lengths for binary strings which comprise one or more context-adaptive entropy coded bins using a summation over, for each of the one or more context-adaptive entropy coded bins, a logarithmized version of the probability estimate (P_{C#}) (see, for example, Eq. 2 above) of the entropy coding context (C#) for the respective context-adaptive entropy coded bin. It is noted that the contexts may differ from the actually used ones of the binary context-adaptive entropy coding such as by leaving off inter-weight dependencies. The logarithmized version may comprise a binary logarithm (e.g., ln() or log₂()) of a probability estimate or a modified version thereof (e.g., with a scaling factor and/or offset). The logarithmized version may have a negative scaling factor (e.g., -1 or a different negative number). For example, the logarithmized version may be -log₂(P_{C#}) or may be determined based on -log₂(P_{C#}).

Figure 9 shows an example of a probability estimation of an entropy coding context for context adaptive entropy coded bins.

The binary strings 16 comprises a significance flag 50 ("sig"), a sign flag 52 ("sign"), a greater-than-one flag 54 ("gt1"), up to N-1 greater-than-X flags 56 ("gt2" to "gtN"), and a remainder binarization 58. However, the binary string 16 may have any structure or number of flags. It is noted that a simplier binarization may be employed. For example the binary string may only comprise a significance flag 50 and a sign flag 52.

A probability estimate P₁ of the significance flag 50 may be determined as a ratio (or fraction) between a number of non-zero quantization indices qᵢ (|qᵢ| > 0) and a total number of quantization indices qᵢ. (e.g., within a set of quantization indices such as within a tensor or a subset thereof). In other words, the probability estimate P₁ may be determined as a fraction of non-zero quantization indices qᵢ relative to all quantization indices qᵢ of a set, e.g., the tensor. For example, if half the quantization indices qᵢ of a tensor (e.g., 500 out of 1000) have a value of zero (i.e. having a significance flag 50 that indicates a value of zero, e.g., by the flag having a value of "0"), the probability estimate P₁ may be defined as 0.5.

Similarly, a probability estimate P₂ of the sign flag 52 may be determined as a ratio between a number of negative quantization indices qᵢ (qᵢ < 0) and a total number of non-zero quantization indices qᵢ (|qᵢ| > 0). In other words, the probability estimate P₂ may as a fraction of negative quantization indices qᵢ relative to the non-zero quantization indices qᵢ of a set, e.g., the tensor). For example, if 20% (e.g., 100 out of 500) of non-zero quantization indices qᵢ are negative, the probability estimate P₂ may be defined as 0.2.

For the greater-than-one flag 54, there may be a probability estimate P₃ₐ determined for a ratio between a number of quantization indices qᵢ smaller than -1 (qᵢ < -1) and a number of quantization indices qᵢ smaller than 0 (qᵢ < 0) as well as a probability estimate P_{3b} determined for a ratio between a number of quantization indices qᵢ greater than 1 (qᵢ > 1) and a number of quantization indices qᵢ greater than 0 (qᵢ > 1).

Similar, for the greater-than-two flag 56, a probability estimate P₄ₐ may be determined for a ratio between a number of quantization indices qᵢ smaller than -2 (qᵢ < -2) and a number of quantization indices qᵢ smaller than 0 (qᵢ < 0) and vice versa for P_{4b}.

As a result, for each quantization index qᵢ, a plurality of probability estimate P_{i,C} can be determined, wherein C# indicates the coding context of individual flags (e.g., C1 for significance flag 50) for each quantization index qᵢ.

The bit lengths for a binary string can subsequently be determined (or approximated) based on logarithmized versions of the probability estimates P_{i,C}. For example, for a P₁ with a value of 0.5, the logarithmized version may be -log₂(0.5) ≈ 0.69. In another example, for a P₂ with a value of 0.2, the logarithmized version may be -log₂(0.2) ≈ 1.61. The bit lengths for binary strings of a quantization index qᵢ may be determined as or on a basis of a sum of all the logarithmized versions of the probability estimates P_{i,C} of the respective quantization index qᵢ. For example a bit length bᵢ of a binary string of a quantization index qᵢ may be determined using the formula ${b}_{i} = {\sum }_{C #} \left(-{log}_{2}\left({P}_{i , C #}\right)\right)$ with all probability estimate P_{i,C#} available from the binarization of quantization index qᵢ. However, other factors (e.g., scaling factors) may be used for determining the bit lengths. **In** the case that the binary string 16 comprises a remainder 58, a fixed bit length may be assumed for the remainder 58 such as a bit length of 1 (or any other value between 0.5 and 2.5, e.g., between 0.8 and 1.2). The total bit length of a binary string (or an approximation of the bit length) may be determined as or on a basis of a sum of the sum of all the logarithmized versions of the probability estimates P_{i,C} and optionally the fixed bit length (e.g., one bit) of a remainder 58, if included in the bit string 16. During encoding, the remainder 58 may be encoded using Exponential Golomb code (or any other suitable code).

Furthermore, a bitrate may be determined, e.g., by normalizing the bitlength relative to a an amount of weights of a set of weights (e.g., the weights of a tensor of layer, e.g., the number of bits normalized by an overall number of weights; that correspond to a set of quantization indices qᵢ). For example, for a set of quantization indices qᵢ, with i = 1 to M (or a network 10 with M weights), the bitrate of a quantization parameter with quantization index qᵢ may be the bit length determined for the respective quantitation parameter (e.g., determined by a sum of logarithmized versions of the probability estimates P_{i,C}) divided by M. **It** is noted that the determined bit lengths for a binary string may be an approximation of the actual bit length that would be used for coding the weights and do not necessarily have to represent the actual bit length or bit rate.

The determined bitrate or bitlength can be used to determine the diescrete function 22. For example, the discrete function 22 may assign a determined value for the bitrate (e.g., sum of all the logarithmized versions of the probability estimates P_{i,C}, wherein, for example, the sum is normalized by an overall number of weights) or the bitlength (e.g., sum of all the logarithmized versions of the probability estimates P_{i,C}) to quantization levels or quantization indices qᵢ (e.g., an integer, e.g., ... -3, -2, -1, 0, 1, 2, 3 ...).

An example of such a discrete function 22 is depicted at the bottom right of fig. 6 and 7 by individual points 40 with cross-shaped symbols. It is not uncommon for a value distribution of weights of a neural network to be larger around zero (e.g., to have more smaller than larger weights). In such a case, the more common quantization indices qᵢ in form of zero, minus one, and plus one yield a smaller logarithmized versions of the probability estimates P_{i,C}, resulting in a discrete function 22 with a minimum around a quantization index of zero. However, the actual shape of the discrete function 22 may look different and may depend on the weights and their distribution in the neural network (or the tensor or subset for which the function R is to be determined).

The method comprises forming 24 the weights-to-bitrate or weights-to-bitlength function R by a summation of, for each of the weights wᵢ, an approximation function *R̃ᵢ* approximating the discrete function 22 at an abscissa position 26 corresponding to the respective weight (e.g. at the unquantized value of the respective weight or the respective weight divided by a quantization step size).

To this end, the method may comprise approximating the discrete function 22 at the abscissa position 26 corresponding to the respective weight using a linear function so that the approximation function and the weights-to-bitrate or weights-to-bitlength function are linear functions.

Fig. 6 and 7, show an example of an approximation function *R̃ᵢ* (in form of a dashed line) for a weight wᵢ.

The method may comprise determining or identifying two (e.g., subsequent) quantization levels or the quantization indices that form an interval (e.g., an interval [qᵢ, qᵢ₊₁]) that comprises the weight wᵢ. In the example of fig 6 and 7, weight wᵢ may have a value (e.g., 2.7) between quantization levels or the quantization indices 2 and 3. For example, the method may comprise determining two quantization levels or the quantization indices closest two the weight wᵢ. In a way, the weight wᵢ functions as a "localizer" along the quantization index or quantization level that allows determining where (e.g., in the vicinity of which quantization index or level) the approximation function *R̃ᵢ* is to be determined, wherein the discrete function 22 (at said vicinity) largely determines the shape of the approximation function *R̃ᵢ*.

Determining the approximation function *R̃ᵢ* may, for example, comprise determining a linear function that defines a straight line through the bitrate values of the discrete function 22 of said two quantization levels or the quantization indices. However, the linear function does not necessarily have to go through these two bitrate values. For example, the linear function may be determined as a tangent of a continuous (e.g., spline) function as described further below.

The method may comprise performing an interpolation (e.g. piecewise linear or spline interpolation) between points 40 of the discrete function 22 (accordingly: e.g., piecewise linear function or spline function) to obtain a continuous function 42 and determine, for each of the weights wᵢ, the approximation function *R̃ᵢ* as an approximation of the continuous function 42 at the abscissa position 26 corresponding to the respective weight (e.g. at the unquantized value of the respective weight or the respective weight divided by a quantization step size).

Fig. 6 and 7 show a continuous function 42 in form of a dot-dashed line that approximates the points 40 of the discrete function.

The spline interpolation may be based on a subset of quantization levels or the quantization indices in a vicinity (e.g., the closest three, four, five, or more quantization levels) of the weight wᵢ. Alternatively, the interpolation may be based on quantization levels or the quantization indices (e.g., that are available, e.g., for quantization indices qᵢ for which a binary string has been obtained during binarization). A spline interpolation based on a larger set of quantization levels or the quantization indices may be reused for a plurality of weights wᵢ, which decreased processing complexity. A spline interpolation based on a smaller set of quantization levels or the quantization indices may result in an improved local approximation around a weight wᵢ.

The method may comprise using a quantization using a predetermined quantization step size (e.g., Δ) so as to determine the quantized version of the weights wᵢ and determining the quantization indices qᵢ of quantization levels of the weights, respectively. The method may comprise determining the discrete function 22 so that the discrete function 22 maps the quantization indices qi or quantization levels onto the bitrates. The method may further comprise performing an interpolation between points 40 of the discrete function 22 to obtain a continuous function 42, and determining, for each of the weights wᵢ, the abscissa position 26 by dividing the respective weight wᵢ by a predetermined quantization step size (e.g., Δ; e.g., and suppressing or skipping a rounding operation) and determining the approximated function *R̃ᵢ* as an approximation of the continuous function 42 at the abscissa position 26.

For example, a weight wᵢ may be 7.3 and the step size may be defined as Δ=2. In such a case, the abscissa position 26 may be determined as 7.3/2=3.65. In other words, the weight wᵢ may be mapped to a "theoretical" or "intermediate" (as it does not index an actual quantization level) quantization index of 3.65. It is noted that the functions R and *R̃ᵢ* can be defined dependent on either of the quantization index qᵢ or the weight wᵢ, as said two parameters are interchangeable, e.g., by using a quantization index that can also assume values between integer values (e.g., 3.65), which is compatible with the function R and *R̃ᵢ*, because the discrete function 22 (and function R and *R̃ᵢ*, derivable therefrom) can be determined based on the probability estimates P#.

In the following, the functions *R̃ᵢ* and R is treated as dependent on wᵢ, in order to easier perform derivation with respect to weights. However, functions *R̃ᵢ* and R may also be used in a form dependent on a similar or equal parameter (e.g., dependent on qᵢ) if the equations are accordingly adjusted.

The approximation function *R̃ᵢ* may subsequently define a (e.g., linear) function dependent on a weight. The parameter of the weight may be performed in different ways, wherein two examples will be described in the following. The parameter allows determining a gradient of the approximation function *R̃ᵢ*, which can be used for updating the respective weight.

According to a first example, the approximation function *R̃ᵢ* may be parameterized with a difference Δwᵢ relative to the weight wᵢ (or *ŵᵢ*) with the weight with which the forward-pass was performed (e.g., depending on whether the forward-pass was performed with the weight or the quantized version thereof). In such a case, the approximation function *R̃ᵢ* may depend on Δwᵢ, e.g., in the form of *R̃ᵢ*(Δ*wᵢ*)*.* When using the gradient to update the weight, the method may comprise determining which difference Δwᵢ is to be applied to wᵢ (or *ŵᵢ*).

According to a second example, the approximation function *R̃ᵢ* a variable weight w_{i,v}, e.g., as *R̃ᵢ*(*w_{i,v}*). When using the gradient to update the weight, the method may comprise determining which value of w_{i,v} is to be set as an updated wᵢ (or *ŵᵢ*)*.*

The first and second example essentially differ in an offset of the weight parameter. Therefore, the parametrization according to *R̃ᵢ*(*w_{i,v}*) essentially corresponds to a parametrization according to *R̃ᵢ*(*wᵢ* + Δ*wᵢ*).

In either case, for each weight wᵢ (or *ŵᵢ*), a corresponding approximation function *R̃ᵢ* can be determined. For example, if the neural network (or a subset or tensor thereof) comprises M quantization indices i, M approximation functions *R̃ᵢ* can be determined. It is noted that, while each approximation function *R̃ᵢ* is parametrized along the weight (or quantization index i or quantization level), each approximation function *R̃ᵢ* has a weight parameter different from other approximation function *R̃ᵢ*.

The weights-to-bitrate or weights-to-bitlength function R is formed by a summation of the approximation function *R̃ᵢ* for each of the weights wᵢ. For example, the function R may be determined using equation $R = {\sum }_{i} {{R}^{˜}}_{i}$

As discussed above, every approximation function *R̃ᵢ* has its own weight parameter. In such a case, for example, with M quantization indices qᵢ,the weights-to-bitrate or weights-to-bitlength function R has M weight parameters, which may be available for derivation (e.g., for determining a gradient).

The method comprises forming 28 a combined loss function L_{P,R} (see, for example, Eq. 1 above) based on a performance loss function L_{P} of the forward-passes and the weights-to-bitrate or weights-to-bitlength function R.

The loss function L_{P} may be determined or defined based on a loss determined as or based on a loss or deviation or distance between an output (e.g., of the forward pass) and a target. The target bay be an anticipated target output of the neural network for a training set. The loss may be measured using one of several measure types such as a cross entropy loss (e.g., when using an image classification model, e.g., a model classifying a plurality of images). The loss may be determined, e.g., based on an output of the neural network in form of or based on a vector (e.g., having a length that is related to a number of classifications) including measures for an input data (e.g., an image) being associated with a classification (e.g., a classification the image).

In a non-limiting example for better understanding, the neural network may be trained and/or configured to classify an object in an input image. The output of the neural network may comprise a vector that indicates a probability of classification performed by the network (e.g., a vector with a thousand entries for a thousand classes and each entry of the output vector indicates a probability that the object in the image can be classified according to the respective classes). The class of the actual object in the input image may be defined as a target. The loss function L_{P} may be determined based on a loss or deviation or distance between the (classification of) the output vector and the (classification of) the target.

Broadly speaking, the combined loss function (L_{P,R}) therefore comprises a function that allows measuring a performance of the neural network (in form of the performance loss function L_{P}) and a function that allows measuring an effect that the weights have on a bitrate for binary context-adaptive entropy coding. Therefore, the combined loss function (L_{P,R}) enables updating or adjusting the weights while considering the network performance and the bitrate.

The method may comprise forming the combined loss function by a linear combination using a Lagrangian multiplier. For example, the combined loss function L_{P,R} may be defined as or based on the following equation: ${L}_{P , R} = {L}_{P} + λR$ where *λ* is a Lagrange multiplier and the determined weights-to-bitrate or weights-to-bitlength function R.

The method further comprises determining 30, for each weight, a gradient 32 of the combined loss function L_{P,R} and using 34 the gradient to update the (unquantized) respective weight for a next cycle (e.g., next training cycle, wherein each cycle comprises a training of the neural network and an updating or adjustment of weights of the neural network).

The gradients 32 of the combined loss function L_{P,R} may be determined in form of separate formulas (e.g., performing a derivative of the combined loss function (L_{P,R}) with respect to the weight of each approximation function (*R̃ᵢ*), resulting in separate derivatives; e.g., M derivatives) or as one formula that includes a sum of said derivatives. A gradient 32 may be determined by differentiating the combined loss function L_{P,R} relative to *w_{i,v}* (e.g., *δ*(*L_{P,R}*)/*δw_{i,v}*) or Δ*wᵢ* (e.g., (*L_{P,R}*)/*δ*Δ*wᵢ*).

The gradients 32 may be used for determining a compromise between improving neural network performance and bitrate. For example, the gradients 32 may be used for determining a (local) minimum of the combined loss function L_{P,R}. For example, the gradients 32 may be used for performing a gradient descent of the combined loss function L_{P,R}.

As a result, the weights may be updated in consideration not only of the network performance but also the birate.

The method may comprise perform forward-passes 12 using the quantized version (*ŵᵢ*) of the weights (wᵢ) of the neural network.

The method may comprise outputting, as the neural network representation, quantization indices ( ${q}_{i}^{last cycle}$) of the quantized version of the weights as updated in a last cycle. The method may comprise iterating the process of updating the weights (or the quantization indices) for more than one (e.g., each) cycle during a training procedure of the neural network.

The method may comprise determining the neural network representation so that same is suitable for being encoded using DeepCABAC.

As already discussed above, further is provided an apparatus for determining, by training, a neural network representation suitable for being encoded using quantization and binary context-adaptive entropy coding. The apparatus is configured to is, cyclically, perform forward-passes using a quantized version of weights wi) of a neural network or using the weights of a neural network, and to determine a weights-to-bitrate or weights-to-bitlength function by determining, for each of a plurality of entropy coding contexts, a probability estimate depending on statistics of binary strings obtained from quantization indices of quantization levels of the weights by binarization using a predetermined binarization scheme, or the quantization indices, determining a discrete function mapping the quantization levels or the quantization indices onto bitrates by determining bit lengths for binary strings which comprise one or more context-adaptive entropy coded bins using a summation over, for each of the one or more context-adaptive entropy coded bins, a logarithmized version of the probability estimate of the entropy coding context for the respective context-adaptive entropy coded bin, forming the weights-to-bitrate or weights-to-bitlength function by a summation of, for each of the weights, an approximation function approximating the discrete function at an abscissa position corresponding to the respective weight. The apparatus is further configured to form a combined loss function based on a performance loss function of the forward-passes and the weights-to-bitrate or weights-to-bitlength function, determine, for each weight, a gradient of the combined loss function and using the gradient to update the respective weight for a next cycle.

The apparatus may be configured to perform any method step disclosed herein. Likewise, any functionality of the apparatus disclosed herein may be performed by the method disclosed herein.

The apparatus may be or may comprise at least one of a computer, a server, a server-cluster, a cloud computing system (e.g., comprising at least one of cloud storage and cloud computing power), a mobile phone, a tablet, a gaming console, and any other computing device (e.g., a computer of an electric car).

Further is provided a bitstream 100 having, by binary context-adaptive entropy coding 102, a neural network representation 104 encoded thereinto, which has been determined by the method and/or apparatus disclosed herein.

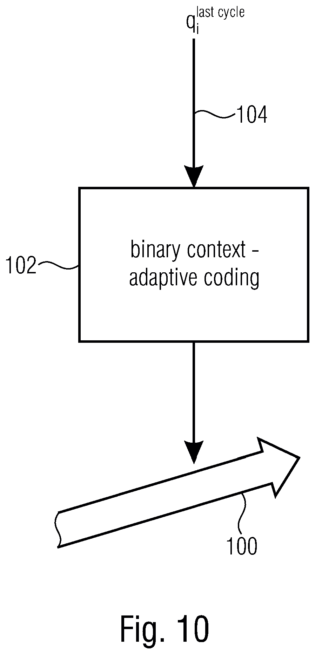

Figure 10 shows a schematic view of an example of a bitstream 100, having, by binary context-adaptive entropy coding 102, a neural network representation 104 encoded there-into. The bitstream may comprise (e.g., output by the method described herein) as the neural network representation 104, quantization indices ( ${q}_{i}^{last cycle}$) of the quantized version of the weights as updated in a last cycle. Since the weights are updated by using 34 the gradient to update the (unquantized) respective weight for a next cycle, the upated weights can be optimized or improved in regards to bitrate. As a result, the bitstream may be coded more efficiently.

The bitstream 100 may be encoded at an end of a training of the neural network and/or after one of multiple steps of updating the respective weights for a next cycle.

The binary context-adaptive entropy coding 102 (for coding the neural network representation into the bitstreasm) may involve a binarization which maps quantization indices of the neural network representation 104 onto binary strings so that the binary strings 16 comprise a significance flag 50 indicative of whether a quantization index to be quantized is zero or not. If the quantization index to be quantized is not zero, the binary strings 16 may comprise a sign flag 52 indicative of whether the quantization index to be quantized is negative or positive, and a greater-than-one flag 54 indicative of whether a magnitude of the quantization index to be quantized is greater than one or not.

If the magnitude of the quantization index to be quantized is greater than one, the binary strings 16 may comprise up to N-1 greater-than-X flags 56 indicative of whether a magnitude of the quantization index to be quantized is greater than X or not, with X assuming values from 2 to N, and if the to be quantized is greater than N, a remainder binarization 58.

The binary context-adaptive entropy coding 102 may involve context-adaptively coding the significance flag, the sign flag, the greater-than-one flag and the N-1 greater-than-X flags of the binary string of a currently coded quantization index by using one out of three first entropy coding contexts (C_{1a/b/c}) for the significance flag, with a section out of the three first entropy coding contexts (C_{1a/b/c}) depending on a zeroness and a sign of a previously coded quantization index, one out of three second entropy coding contexts (C_{2a/b/c}) for the sign flag, with a section out of the three second entropy coding contexts (C2_{a/b/c}) depending on a zeroness and a sign of a previously coded quantization index, for each of the greater-than-one flag and N-2 greater-than-X flag, a respective third entropy coding context (C_{#b}) if the sign flag of the binary string of the currently coded quantization index, indicates positiveness, and a respective fourth entropy coding context (C_{#a}) if the sign flag of the binary string of the currently coded quantization index, indicates negativeness.

The apparatus may be configured to train the neural network on one or more devices and to generate a bitstream having a neural network representation (or at least a portion thereof) encoded therein. For example, the apparatus (e.g., a server) may be configured to train a neural network and to determine a neural network representation (of the trained neural network), which can be subsequently encoded (e.g., by the apparatus or a separate device) using quantization and binary context-adaptive entropy coding. Due to an improved coding efficiency, transmission of the neural network representation (e.g., in form of the bitstream) can be performed more efficiently.

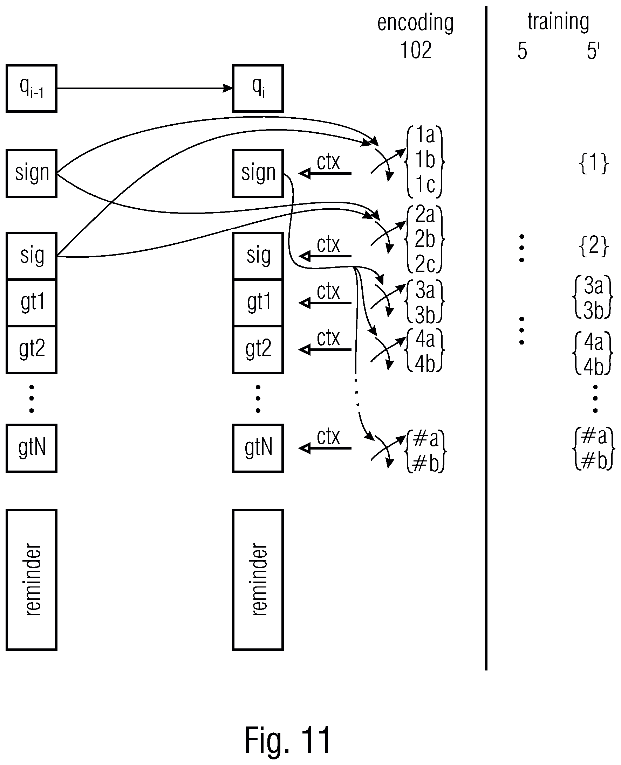

Figure 11 shows a schematic view of examples of coding contexts for encoding 102 and for training 5, 5'. Fig. 11 shows binary strings 16 of a quantization index qᵢ and a preceding quantization index qᵢ₋₁.

During binary context-adaptive entropy coding, context models may be selected based on previous coded values (or bits). For example, when encoding the significance flag ("sign") for the quantization index qᵢ, context models (or coding context) {1a, 1b, 1c} are available and the selection of the context model depends on previously coded values, e.g., on the significance flag ("sign") and sign flag ("sig") of the preceding quantization index qᵢ₋₁. In a similar example, when encoding the sign flag ("sig") for the quantization index qᵢ, context models {2a, 2b, 2c} are available and the selection of the context model depends on previously coded values, e.g., depends on the significance flag ("sign") and sign flag ("sig") of the preceding quantization index qᵢ₋₁.

As can be seen in the example shown in fig. 11, encoded bits of the quantization index qᵢ can also be used to select the context model for subsequent bits of the same quantization index qᵢ. For example, when encoding a greater-than-one flag ("gt1") for the quantization index qᵢ, context models {3a, 3b} are available and the selection of the context model depends on the previously coded bit (or bits) of the same quantization index qᵢ, e.g., depends on the encoded significance flag ("sign") of the quantization index qᵢ.

However, the entropy coding context (or context model) for the training methods enclosed herein (e.g., methods 5 and 5') do not necessarily have to be identical to context models for binary context-adaptive entropy coding. A main purpose of encoding is to obtain encoded bits (e.g., for transmission and/or storage), whereas the method disclosed herein aims to determine the combined loss function (L_{P,R}), for which a gradient can be determined in order to update weights. In order for the combined loss function (L_{P,R}) to be indicative of a relationship between bitrate (or bitlength) and weights, the method determines or approximates a bitlength that may result from binary context-adaptive entropy coding. The approximation does not require actually encoding the weights, but determines combined loss function (L_{P,R}) based on a logarithmized version of the probability estimate (P_{C#}) of the entropy coding context. Therefore, the context models for entropy coding and training do not necessarily have to be (but can be) identical.

### 4 Experimental results

The training methods presented in this disclosure are applied to two state-of-the-art image classification models, ResNet50 and MobileNetV2 pretrained on ImageNet (source: TorchVision v0.11.1 [15]), using, e.g., stochastic gradient decent for parameter optimization.

Here, all method examples described herein are applied to the weight parameters, only. Non-weight parameters (e.g. biases, batch-norm parameters) are neglected, because they usually have a rather small impact on the bitrate but are very sensitive to quantization with respect to the performance. However, the method may be applied to other parameters as well. Different working points are tested by applying selected QP values (quantization step-sizes) as given in Table 1. The hyper-parameters required for the training process are determined experimentally and are set as follows. Each model is trained for 90 epochs with a batch size of 256 and a momentum factor of 0.9. The learning rate is decreased by a factor of 0.1 after 30 and 60 training epochs and is initially set to 0.1 for ResNet50 and to 0.001 for MobileNetV2. The Lagrangian multipliers *λ* are given in Table 1. However, any other parameters for network training may be used.

Then, the retrained models are compressed using the open NNC implementation NNCodec [16], which outputs the bitrate of the compressed model and the model performance of the decoded (quantized) model. Here, NNCodec is configured such that only scalar quantization with URQ, DeepCABAC entropy coding and a DeepCABAC parameter optimization scheme are enabled, in order to capture the effect of quantization and entropy coding only. The QP values used for compression of the weight parameters are the same as in the training process (see table 1). All non-weight parameters are compressed virtually lossless (but may alternatively be compressed lossy).

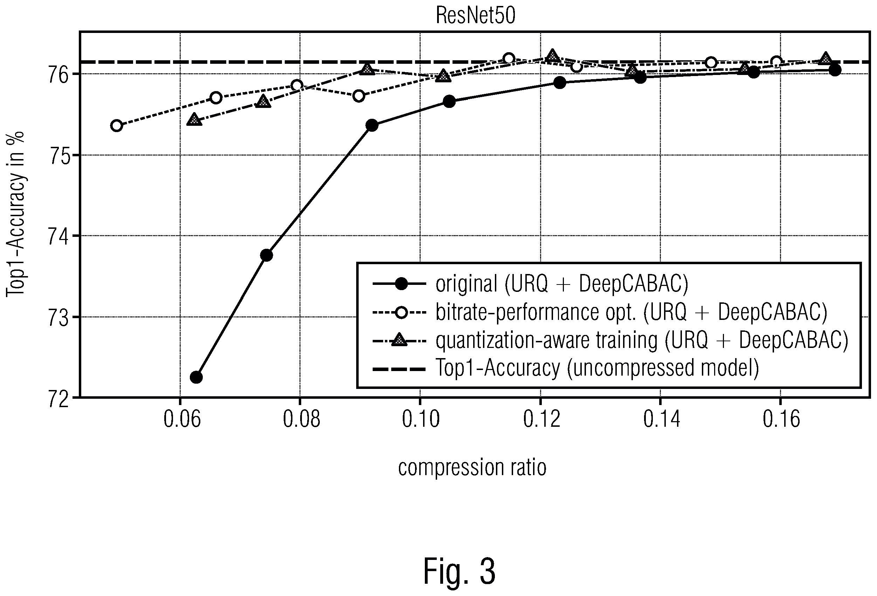

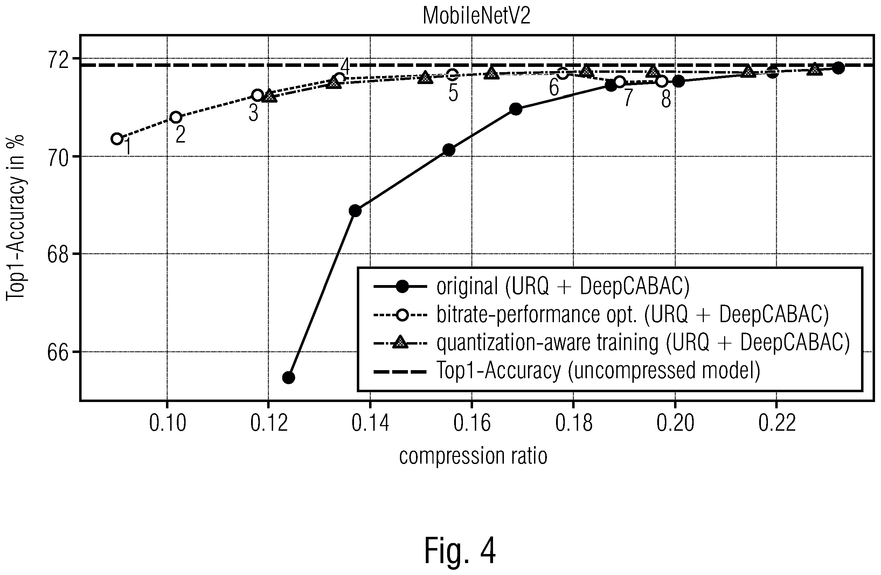

The results are depicted in Fig. 3 and 4 showing the model performance measured as Top1-Accuracy with respect to the compression ratio (compressed model size divided by its original size). Compression gains for the combined bitrate-performance optimized training are given in Table 1. Generally, the presented methods increase the compressibility of the models such that NNC achieves significantly lower bitrates at the same or even increased Top1-Accuracies. Higher bitrate reductions are obtained for coarser quantization, but at a cost of model performance. The QAT method already significantly improves the compressibility and thus the coding efficiency of NNC. However, combining the method with bitrate-aware training further improves the results. With the combined bitrate-performance optimized training, the compression ratio can be reduced by averagely -26.47% for ResNet50 and -25.11% for MobileNetV2 for relevant working points. By allowing some degree of performance degradation, the bitrate can be reduced by up to -46.33% for ResNet50 and -43.43% for MobileNetV2, respectively.

Figure 3 shows an example of results for QAT and Bitrate-performance optimized training for ResNet50

Figure 4 shows an example of results for QAT and Bitrate-Performance optimized training for MobileNetV2

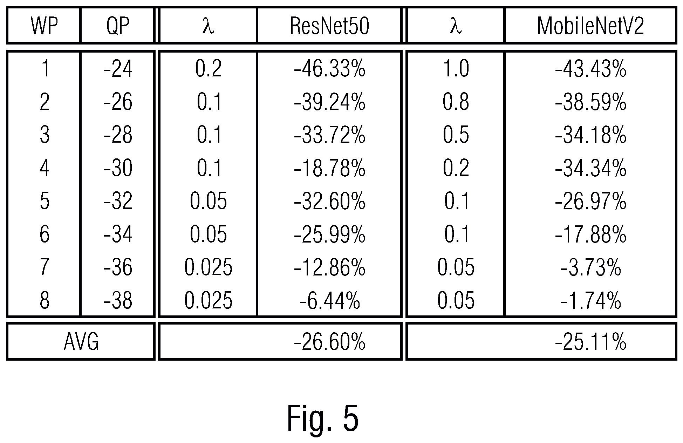

Figure 5 shows a table of an example of compression gains for bitrate-performance optimized training and selected working points.

**Table 1: Compression gains for bitrate-performance optimized training and selected working points (see also fig. 5)**

| WP | QP | *λ* | ResNet50 | *λ* | MobileNetV2 |
|---|---|---|---|---|---|
| | -24 | 0.2 | -46.33% | 1.0 | -43.43% |
| | -26 | 0.1 | -39.24% | 0.8 | -38.59% |
| | -28 | 0.1 | -33.72% | 0.5 | -34.18% |
| | -30 | 0.1 | -18.78% | 0.2 | -34.34% |
| | -32 | 0.05 | -32.60% | 0.1 | -26.97% |
| | -34 | 0.05 | -25.99% | 0.1 | -17.88% |
| | -36 | 0.025 | -12.86% | 0.05 | -3.73% |
| | -38 | 0.025 | -6.44% | 0.05 | -1.74% |
| **AVG** | | **-26.60%** | | **-25.11%** | |

### 5 Conclusions

In this disclosure is presented a new method and apparatus for bitrate-performance optimized training for the NNC standard on compression of neural networks. The method increases the compressibility of NN models such that NNC achieves bitrate reductions of 25.86% in average on state-of-the-art image classification models compared to the compressed pretrained versions. In particular, the method combines a quantization-aware training and a new approach for bitrate-aware training, considering both the quantization and entropy coding process of NNC. Finally, individual coding results are shown for quantization-aware training and the combined bitrate-performance optimized training for relevant working points in order to assess the impact of the presented methods on the bitrate and the performance.

Note for figures:
*#*(*qᵢ*) indicates the number of quantization indices obtain from quantizing the weights, i.e. the number of weights
*#*(|*qᵢ*| > 0) indicates the number of quantization indices obtain from quantizing the weights, whose magnitude exceeds zero
*#*(*qᵢ <* -1) indicates the number of quantization indices obtain from quantizing the weights which are smaller than minus 1
*#*(*qᵢ* < 0) indicates the number of quantization indices obtain from quantizing the weights which are smaller than zero, i.e. negative
*#*(*qᵢ >* 1) indicates the number of quantization indices obtain from quantizing the weights which are greater than 1
*#*(*qᵢ >* 0) indicates the number of quantization indices obtain from quantizing the weights which are greater than zero, i.e. positive
*#*(*qᵢ >* -2) indicates the number of quantization indices obtain from quantizing the weights which are smaller than minus 2
*#*(*qᵢ >* 2) indicates the number of quantization indices obtain from quantizing the weights which are greater than 2

### 6 Further Remarks:

Above, different inventive embodiments and aspects have been described in a chapter "Rate-performance optimized training", in a chapter "Bitrate-aware training", and in a chapter "Quantization-aware training".

Also, further embodiments will be defined by the enclosed claims.

It should be noted that any embodiments as defined by the claims can be supplemented by any of the details (features and functionalities) described in the above mentioned chapters.

Also, the embodiments described in the above mentioned chapters can be used individually, and can also be supplemented by any of the features in another chapter, or by any feature included in the claims.

Also, it should be noted that individual aspects described herein can be used individually or in combination. Thus, details can be added to each of said individual aspects without adding details to another one of said aspects.

It should also be noted that the present disclosure describes, explicitly or implicitly, features usable in video encoder (apparatus for providing an encoded representation of an input video signal). Thus, any of the features described herein can be used in the context of a video encoder.

Moreover, features and functionalities disclosed herein relating to a method can also be used in an apparatus (configured to perform such functionality). Furthermore, any features and functionalities disclosed herein with respect to an apparatus can also be used in a corresponding method. In other words, the methods disclosed herein can be supplemented by any of the features and functionalities described with respect to the apparatuses.

Also, any of the features and functionalities described herein can be implemented in hardware or in software, or using a combination of hardware and software, as will be described in the section "implementation alternatives".

### 7 Implementation alternatives:

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus. Some or all of the method steps may be executed by (or using) a hardware apparatus, like for example, a microprocessor, a programmable computer or an electronic circuit. In some embodiments, one or more of the most important method steps may be executed by such an apparatus.

Depending on certain implementation requirements, embodiments of the invention can be implemented in hardware or in software. The implementation can be performed using a digital storage medium, for example a floppy disk, a DVD, a Blu-Ray, a CD, a ROM, a PROM, an EPROM, an EEPROM or a FLASH memory, having electronically readable control signals stored thereon, which cooperate (or are capable of cooperating) with a programmable computer system such that the respective method is performed. Therefore, the digital storage medium may be computer readable.

Some embodiments according to the invention comprise a data carrier having electronically readable control signals, which are capable of cooperating with a programmable computer system, such that one of the methods described herein is performed.

Generally, embodiments of the present invention can be implemented as a computer program product with a program code, the program code being operative for performing one of the methods when the computer program product runs on a computer. The program code may for example be stored on a machine readable carrier.

Other embodiments comprise the computer program for performing one of the methods described herein, stored on a machine readable carrier.

In other words, an embodiment of the inventive method is, therefore, a computer program having a program code for performing one of the methods described herein, when the computer program runs on a computer.

A further embodiment of the inventive methods is, therefore, a data carrier (or a digital storage medium, or a computer-readable medium) comprising, recorded thereon, the computer program for performing one of the methods described herein. The data carrier, the digital storage medium or the recorded medium are typically tangible and/or non-transitionary.

A further embodiment of the inventive method is, therefore, a data stream or a sequence of signals representing the computer program for performing one of the methods described herein. The data stream or the sequence of signals may for example be configured to be transferred via a data communication connection, for example via the Internet.

A further embodiment comprises a processing means, for example a computer, or a programmable logic device, configured to or adapted to perform one of the methods described herein.

A further embodiment comprises a computer having installed thereon the computer program for performing one of the methods described herein.

A further embodiment according to the invention comprises an apparatus or a system configured to transfer (for example, electronically or optically) a computer program for performing one of the methods described herein to a receiver. The receiver may, for example, be a computer, a mobile device, a memory device or the like. The apparatus or system may, for example, comprise a file server for transferring the computer program to the receiver.

In some embodiments, a programmable logic device (for example a field programmable gate array) may be used to perform some or all of the functionalities of the methods described herein. In some embodiments, a field programmable gate array may cooperate with a microprocessor in order to perform one of the methods described herein. Generally, the methods are preferably performed by any hardware apparatus.

The apparatus described herein may be implemented using a hardware apparatus, or using a computer, or using a combination of a hardware apparatus and a computer.

The apparatus described herein, or any components of the apparatus described herein, may be implemented at least partially in hardware and/or in software.

The methods described herein may be performed using a hardware apparatus, or using a computer, or using a combination of a hardware apparatus and a computer.

The methods described herein, or any components of the apparatus described herein, may be performed at least partially by hardware and/or by software.

The above described embodiments are merely illustrative for the principles of the present invention. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

In the following, additional embodiments and aspects of the invention will be described which can be used individually or in combination with any of the features and functionalities and details described herein.

A first embodiment may have an apparatus for determining, by training, a neural network representation suitable for being encoded using quantization and binary context-adaptive entropy coding, configured to, cyclically, perform forward-passes 12 using a quantized version *ŵᵢ* of weights wᵢ of a neural network 10 or using the weights of a neural network 10, determine a weights-to-bitrate or weights-to-bitlength function R by determining 18, for each of a plurality of entropy coding contexts, a probability estimate P_{C#} depending on statistics of binary strings 16 obtained from quantization indices qᵢ of quantization levels *ŵᵢ* of the weights wᵢ by binarization 14 using a predetermined binarization scheme, or the quantization indices, and determining 20 a discrete function 22 mapping the quantization levels or the quantization indices onto bitrates or bitlengths by determining bit lengths for binary strings which comprise one or more context-adaptive entropy coded bins using a summation over, for each of the one or more context-adaptive entropy coded bins, a logarithmized version of the probability estimate P_{C#} of the entropy coding context C# for the respective context-adaptive entropy coded bin, forming 24 the weights-to-bitrate or weights-to-bitlength function R by a summation of, for each of the weights wᵢ, an approximation function *R̃ᵢ* approximating the discrete function 22 at an abscissa position 26 corresponding to the respective weight; form 28 a combined loss function L_{P,R} based on a performance loss function L_{P} of the forward-passes and the weights-to-bitrate or weights-to-bitlength function R, determine 30, for each weight, a gradient 32 of the combined loss function L_{P,R} and using 34 the gradient to update the respective weight for a next cycle.

According to a second embodiment when referring back to the first embodiment, the apparatus may be configured to approximate the discrete function 22 at the abscissa position 26 corresponding to the respective weight using a linear function so that the approximation function and the weights-to-bitrate or weights-to-bitlength function are linear functions.

According to a third embodiment when referring back to the first or second embodiment, the apparatus may be configured to perform an interpolation between points 40 of the discrete function 22 to obtain a continuous function 42 and determine, for each of the weights, the approximation function *R̃ᵢ* as an approximation of the continuous function 42 at the abscissa position 26 corresponding to the respective weight.

According to a fourth embodiment when referring back to any of the first to third embodiments, the apparatus may be configured to use a quantization using a predetermined quantization step size Δ so as to determine the quantized version of the weights and determine the quantization indices of quantization levels of the weights, respectively.

According to a fifth embodiment when referring back to any of the first to fourth embodiments, the apparatus may be configured to use a quantization using a predetermined quantization step size so as to determine the quantized version of the weights and determine the quantization indices of quantization levels of the weights, respectively, and the apparatus is configured to determine the discrete function so that same maps the quantization indices onto the bitrates, and the apparatus is configured to perform an interpolation between points of the discrete function to obtain a continuous function, determine, for each of the weights, the abscissa position by dividing the respective weight by the predetermined quantization step size and determine the approximated function as an approximation of the continuous function at the abscissa position.

According to a sixth embodiment when referring back to any of the first to fifth embodiments, the binarization maps the quantization indices onto the binary strings so that the binary strings 16 comprise a significance flag 50 indicative of whether a quantization index to be quantized is zero or not, if the quantization index to be quantized is not zero, a sign flag 52 indicative of whether the quantization index to be quantized is negative or positive, and a greater-than-one flag 54 indicative of whether a magnitude of the quantization index to be quantized is greater than one or not, and if the magnitude of the quantization index to be quantized is greater than one, up to N-1 greater-than-X flags 56 indicative of whether a magnitude of the quantization index to be quantized is greater than X or not, with X assuming values from 2 to N, and if the to be quantized is greater than N, a remainder binarization 58, wherein the significance flag, the sign flag, the greater-than-one flag and the N-1 greater-than-X flags are the context-adaptive entropy coded bins, and bins of the remainder binarization are coded.

According to a seventh embodiment when referring back to the sixth embodiment, the apparatus may be configured to use one first entropy coding context C₁ for the significance flag, one second entropy coding context C₂ for the sign flag, for each of the greater-than-one flag and N-2 greater-than-X flag, a respective third entropy coding context C_{#b} if the sign flag of the binary string to which the respective of the greater-than-one flag and N-2 greater-than-X flag belongs, indicates positiveness, and a respective fourth entropy coding context C_{#a} if the sign flag of the binary string to which the respective of the greater-than-one flag and N-2 greater-than-X flag belongs, indicates negativeness.

According to an eighth embodiment when referring back to any of the first to seventh embodiments, the apparatus may be configured to form the combined loss function by a linear combination using a Lagrangian multiplier.

According to a ninth embodiment when referring back to any of the first to eighth embodiments, the apparatus may be configured to output, as the neural network representation, quantization indices ${q}_{i}^{last cycle}$ of the quantized version of the weights as updated in a last cycle.

According to a tenth embodiment when referring back to any of the first to ninth embodiments, the apparatus may be configured to determine the neural network representation so that same is suitable for being encoded using DeepCABAC.

According to an eleventh embodiment when referring back to any of the first to tenth embodiments, the apparatus may be configured to determine 60 the performance loss function of the forward-passes by using a cross entropy loss measure.

According to a twelfth embodiment when referring back to any of the first to eleventh embodiments, the apparatus may be configured to perform forward-passes 12 using the quantized version *ŵᵢ* of the weights wᵢ of the neural network.

A thirteenth embodiment relates to a method for determining, by training, a neural network representation suitable for being encoded using quantization and binary context-adaptive entropy coding, to the method comprising, cyclically, performing forward-passes 12 using a quantized version *ŵᵢ* of weights wᵢ of a neural network 10 or using the weights of a neural network 10, determining a weights-to-bitrate or weights-to-bitlength function R by determining 18, for each of a plurality of entropy coding contexts, a probability estimate P_{C#} depending on statistics of binary strings 16 obtained from quantization indices qᵢ of quantization levels *ŵᵢ* of the weights wᵢ by binarization 14 using a predetermined binarization scheme, or the quantization indices, and determining 20 a discrete function 22 mapping the quantization levels or the quantization indices onto bitrates by determining bit lengths for binary strings which comprise one or more context-adaptive entropy coded bins using a summation over, for each of the one or more context-adaptive entropy coded bins, a logarithmized version of the probability estimate P_{C#} of the entropy coding context C# for the respective context-adaptive entropy coded bin, forming 24 the weights-to-bitrate or weights-to-bitlength function R by a summation of, for each of the weights wᵢ, an approximation function *R̃ᵢ* approximating the discrete function 22 at an abscissa position 26 corresponding to the respective weight; forming 28 a combined loss function L_{P,R} based on a performance loss function L_{P} of the forward-passes and the weights-to-bitrate or weights-to-bitlength function R, determining 30, for each weight, a gradient 32 of the combined loss function L_{P,R} and using 34 the gradient to update the respective weight for a next cycle.

A fourteenth embodiment relates to a bitstream 100 having, by binary context-adaptive entropy coding 102, a neural network representation 104 encoded thereinto, which has been determined by the method according to the invention as mentioned above.

According to a fifteenth embodiment when referring back to the fourteenth embodiment, the binary context-adaptive entropy coding 102 involves a binarization which maps quantization indices of the neural network representation 104 onto binary strings so that the binary strings 16 comprise a significance flag 50 indicative of whether a quantization index to be quantized is zero or not, if the quantization index to be quantized is not zero, a sign flag 52 indicative of whether the quantization index to be quantized is negative or positive, and a greater-than-one flag 54 indicative of whether a magnitude of the quantization index to be quantized is greater than one or not, and if the magnitude of the quantization index to be quantized is greater than one, up to N-1 greater-than-X flags 56 indicative of whether a magnitude of the quantization index to be quantized is greater than X or not, with X assuming values from 2 to N, and if the to be quantized is greater than N, a remainder binarization 58, wherein the binary context-adaptive entropy coding 102 involves context-adaptively coding the significance flag, the sign flag, the greater-than-one flag and the N-1 greater-than-X flags of the binary string of a currently coded quantization index by using one out of three first entropy coding contexts C_{1a/b/c} for the significance flag, with a section out of the three first entropy coding contexts C_{1a/b/c} depending on a zeroness and a sign of a previously coded quantization index, one out of three second entropy coding contexts C_{2a/b/c} for the sign flag, with a section out of the three second entropy coding contexts C2_{a/b/c} depending on a zeroness and a sign of a previously coded quantization index, for each of the greater-than-one flag and N-2 greater-than-X flag, a respective third entropy coding context C_{#b} if the sign flag of the binary string of the currently coded quantization index, indicates positiveness, and a respective fourth entropy coding context C_{#a} if the sign flag of the binary string of the currently coded quantization index, indicates negativeness.

### References

[1] K. Ota, M. S. Dao, V. Mezaris, and F. G. B. D. Natale, "Deep learning for mobile multimedia: A survey," ACM Trans. Multimedia Comput. Commun. Appl., vol. 13, no. 3s, jun 2017. [Online]. Available: https://doi.org/10.1145/3092831
[2] X. Xu, Y. Ding, S. X. Hu, M. Niemier, J. Cong, Y. Hu, and Y. Shi, "Scaling for edge inference of deep neural networks," Nature Electronics, vol. 1, no. 4, pp. 216-222, 2018. [Online]. Available: https://doi.org/10.1038/s41928-018-0059-3
[3] H. B. McMahan, E. Moore, D. Ramage, and B. A. y Arcas, "Federated learning of deep networks using model averaging," CoRR, vol. abs/1602.05629, 2016. [Online]. Available: http://arxiv.org/abs/1602.05629
[4] F. Sattler, S. Wiedemann, K. M¨uller, and W. Samek, "Robust and communication-efficient federated learning from non-i.i.d. data," IEEE Transactions on Neural Networks and Learning Systems, pp. 1-14, 2019.
[5] H. Kirchhoffer et al., "Overview of the neural network compression and representation (nnr) standard," IEEE Transactions on Circuits and Systems for Video Technology, vol. 32, no. 5, pp. 3203-3216, 2022.
[6] S. Wiedemann et al., "Deepcabac: A universal compression algorithm for deep neural networks," CoRR, vol. abs/1907.11900, 2019. [Online]. Available: http://arxiv.org/abs/1907.11900
[7] T. Hoefler, D. Alistarh, T. Ben-Nun, N. Dryden, and A. Peste, "Sparsity in deep learning: Pruning and growth for efficient inference and training in neural networks," J. Mach. Learn. Res., vol. 22, no. 1, jul 2022.
[8] P. Haase, D. Becking, H. Kirchhoffer, K. Müller, H. Schwarz,W. Samek, D. Marpe, and T.Wiegand, "Encoder optimizations for the nnr standard on neural network compression," in 2021 IEEE International Conference on Image Processing (ICIP), 2021, pp. 3522-3526.
[9] P. Haase, H. Schwarz, H. Kirchhoffer, S. Wiedemann, T. Marinc, A. Marban, K. M¨uller, W. Samek, D. Marpe, and T. Wiegand, "Dependent scalar quantization for neural network compression," in 2020 IEEE International Conference on Image Processing (ICIP), 2020, pp. 36-40.
[10] D. Marpe, H. Schwarz, and T.Wiegand, "Context-based adaptive binary arithmetic coding in the H.264/AVC video compression standard," IEEE Transactions on Circuits and Systems for Video Technology, vol. 13, no. 7, pp. 620-636, Jul. 2003.
[11] J. Teuhola, "A compression method for clustered bitvectors." Inf. Process. Lett., vol. 7, pp. 308-311, 10 1978.
[12] H. Wu, P. Judd, X. Zhang, M. Isaev, and P. Micikevicius, "Integer quantization for deep learning inference: Principles and empirical evaluation," CoRR, vol. abs/2004.09602, 2020. [Online]. Available: https://arxiv.org/abs/2004.09602
[13] Y. Bengio, N. L´eonard, and A. C. Courville, "Estimating or propagating gradients through stochastic neurons for conditional computation," CoRR, vol. abs/1308.3432, 2013. [Online]. Available: http://arxiv.org/abs/1308.3432
[14] P. Yin, J. Lyu, S. Zhang, S. J. Osher, Y. Qi, and J. Xin, "Understanding straight-through estimator in training activation quantized neural nets," CoRR, vol. abs/1903.05662, 2019. [Online]. Available: http://arxiv.org/abs/1903.05662
[15] TorchVision maintainers and contributors. "Torchvision: Pytorch's computer vision library," GitHub.com, https://github.com/pytorch/vision (accessed Jan. 31, 2023), 2016.
[16] P. Haase and D. Becking, "Fraunhofer neural network encoder/decoder (nncodec)," GitHub.com, https://github.com/fraunhoferhhi/nncodec (accessed Jan. 31, 2023), 2022.

## Claims

1. Apparatus for determining, by training, a neural network representation suitable for being encoded using quantization and binary context-adaptive entropy coding, configured to, cyclically,
perform forward-passes (12) using a quantized version (*ŵᵢ*) of weights (wᵢ) of a neural network (10),
determine a weights-to-bitrate or weights-to-bitlength function (R) by
determining (18), for each of a plurality of entropy coding contexts, a probability estimate (P_{C#}) depending on statistics of binary strings (16) obtained from quantization indices (qᵢ) of quantization levels (*ŵᵢ*) of the weights (wᵢ) by binarization (14) using a predetermined binarization scheme, or the quantization indices, and
determining (20) a discrete function (22) mapping the quantization levels or the quantization indices onto bitrates or bitlengths by determining bit lengths for binary strings which comprise one or more context-adaptive entropy coded bins using a summation over, for each of the one or more context-adaptive entropy coded bins, a logarithmized version of the probability estimate (P_{C#}) of the entropy coding context (C#) for the respective context-adaptive entropy coded bin,
forming (24) the weights-to-bitrate or weights-to-bitlength function (R) by a summation of, for each of the weights (wᵢ), an approximation function (*R̃ᵢ*) approximating the discrete function (22) at an abscissa position (26) corresponding to the respective weight;
form (28) a combined loss function (L_{P,R}) based on a performance loss function (L_{P}) of the forward-passes and the weights-to-bitrate or weights-to-bitlength function (R),
determine (30), for each weight, a gradient (32) of the combined loss function (L_{P,R}) and using (34) the gradient to update the respective weight for a next cycle.

2. The apparatus according to claim 1, wherein
the apparatus is configured to approximate the discrete function (22) at the abscissa position (26) corresponding to the respective weight using a linear function so that the approximation function and the weights-to-bitrate or weights-to-bitlength function are linear functions.

3. The apparatus according to claim 1 or 2, wherein
the apparatus is configured to perform an interpolation between points (40) of the discrete function (22) to obtain a continuous function (42) and determine, for each of the weights, the approximation function (*R̃ᵢ*) as an approximation of the continuous function (42) at the abscissa position (26) corresponding to the respective weight.

4. The apparatus of any previous claims, wherein
the apparatus is configured to use a quantization using a predetermined quantization step size (Δ) so as to determine the quantized version of the weights and determine the quantization indices of quantization levels of the weights, respectively.

5. The apparatus of any previous claims, wherein
the apparatus is configured to use a quantization using a predetermined quantization step size so as to determine the quantized version of the weights and determine the quantization indices of quantization levels of the weights, respectively, and
the apparatus is configured to determine the discrete function so that same maps the quantization indices onto the bitrates, and
the apparatus is configured to perform an interpolation between points of the discrete function to obtain a continuous function, determine, for each of the weights, the abscissa position by dividing the respective weight by the predetermined quantization step size and determine the approximated function as an approximation of the continuous function at the abscissa position.

6. The apparatus of any previous claim, wherein
the binarization maps the quantization indices onto the binary strings so that the binary strings (16) comprise
a significance flag (50) indicative of whether a quantization index to be quantized is zero or not,
if the quantization index to be quantized is not zero,
a sign flag (52) indicative of whether the quantization index to be quantized is negative or positive, and
a greater-than-one flag (54) indicative of whether a magnitude of the quantization index to be quantized is greater than one or not, and
if the magnitude of the quantization index to be quantized is greater than one,
up to N-1 greater-than-X flags (56) indicative of whether a magnitude of the quantization index to be quantized is greater than X or not, with X assuming values from 2 to N, and
if the to be quantized is greater than N, a remainder binarization (58),
wherein the significance flag, the sign flag, the greater-than-one flag and the N-1 greater-than-X flags are the context-adaptive entropy coded bins, and bins of the remainder binarization are coded.

7. The apparatus of claim 6, configured to use
one first entropy coding context (C₁) for the significance flag,
one second entropy coding context (C₂) for the sign flag,
for each of the greater-than-one flag and N-2 greater-than-X flag,
a respective third entropy coding context (C_{#b}) if the sign flag of the binary string to which the respective of the greater-than-one flag and N-2 greater-than-X flag belongs, indicates positiveness, and
a respective fourth entropy coding context (C_{#a}) if the sign flag of the binary string to which the respective of the greater-than-one flag and N-2 greater-than-X flag belongs, indicates negativeness.

8. The apparatus of any previous claim, configured to form the combined loss function by a linear combination using a Lagrangian multiplier.

9. The apparatus of any previous claim, configured to output, as the neural network representation, quantization indices ( ${q}_{i}^{last cycle}$) of the quantized version of the weights as updated in a last cycle.

10. The apparatus of any previous claim, configured to determine the neural network representation so that same is suitable for being encoded using DeepCABAC.

11. The apparatus of any previous claim, configured to determine (60) the performance loss function of the forward-passes by using a cross entropy loss measure.

12. Method for determining, by training, a neural network representation suitable for being encoded using quantization and binary context-adaptive entropy coding, the method being computer-implemented and comprising, cyclically,
performing forward-passes (12) using a quantized version (*ŵᵢ*) of weights (wᵢ) of a neural network (10),
determining a weights-to-bitrate or weights-to-bitlength function (R) by
determining (18), for each of a plurality of entropy coding contexts, a probability estimate (P_{C#}) depending on statistics of binary strings (16) obtained from quantization indices (qᵢ) of quantization levels (*ŵᵢ*) of the weights (wᵢ) by binarization (14) using a predetermined binarization scheme, or the quantization indices, and
determining (20) a discrete function (22) mapping the quantization levels or the quantization indices onto bitrates by determining bit lengths for binary strings which comprise one or more context-adaptive entropy coded bins using a summation over, for each of the one or more context-adaptive entropy coded bins, a logarithmized version of the probability estimate (P_{C#}) of the entropy coding context (C#) for the respective context-adaptive entropy coded bin,
forming (24) the weights-to-bitrate or weights-to-bitlength function (R) by a summation of, for each of the weights (wᵢ), an approximation function (*R̃ᵢ*) approximating the discrete function (22) at an abscissa position (26) corresponding to the respective weight;
forming (28) a combined loss function (L_{P,R}) based on a performance loss function (L_{P}) of the forward-passes and the weights-to-bitrate or weights-to-bitlength function (R),
determining (30), for each weight, a gradient (32) of the combined loss function (L_{P,R}) and using (34) the gradient to update the respective weight for a next cycle.
